(19) Europäisches Patentamt
European Patent Office
Office européen des brevets

(11) Publication number: **0 033 033**
**B1**

(12) **EUROPEAN PATENT SPECIFICATION**

(45) Date of publication of patent specification: **20.03.85**

(51) Int. Cl.[4]: **H 03 K 3/353**

(21) Application number: **80304548.3**

(22) Date of filing: **17.12.80**

(54) **A Schmitt trigger circuit, for example for use in a dynamic MIS memory circuit.**

(30) Priority: **29.12.79 JP 171184/79**

(43) Date of publication of application:
**05.08.81 Bulletin 81/31**

(45) Publication of the grant of the patent:
**20.03.85 Bulletin 85/12**

(84) Designated Contracting States:
**DE FR GB NL**

(56) References cited:
**US-A-3 407 339**
**US-A-3 678 293**
**US-A-3 714 466**
**US-A-3 873 856**
**US-A-3 959 782**
**US-A-4 000 427**
**US-A-4 101 788**

(73) Proprietor: **FUJITSU LIMITED**
**1015, Kamikodanaka Nakahara-ku**
**Kawasaki-shi Kanagawa 211 (JP)**

(72) Inventor: **Hirao, Hiroshi**
**No. 11 Sugao Takatsu-ku**
**Kawasaki-shi Kanagawa 213 (JP)**

(74) Representative: **Sunderland, James Harry**
**HASELTINE LAKE & CO Hazlitt House 28**
**Southampton Buildings Chancery Lane**
**London WC2A 1AT (GB)**

**EP 0 033 033 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a Schmidt trigger circuit. Schmidt trigger circuits are commonly employed for delaying signals, for example, in dynamic MIS memory circuit.

A MIS transistor having a gate electrode formed of polycrystalline silicon can be used as a memory cell in a dynamic MIS memory circuit.

Polycrystalline silicon has a resistance notably higher than that of Al and other wiring materials. Accordingly, when a drive circuit disposed on one side of a memory cell array is connected with gate electrodes of MIS transistors forming memory cells of the memory cell array, for example, when reading out the memory cells, information can be read out immediately from memory cells lying near the drive circuit, but reading out of information from memory cells situated away from the drive circuit is delayed because the high resistance property of the polycrystalline silicon and the presence of capacitance causes a time lag in the transmission of a signal to such memory cells from the drive circuit. Therefore, if an output circuit for the output of read-out information is driven by the same signal as that applied to the memory cells notwithstanding that the time of reading out of information varies in dependence upon the position of the memory cell being read, then accurate information cannot be obtained.

To avoid this problem, a circuit arrangement as shown in Figure 1 of the accompanying drawings, which is a schematic block diagram, has been proposed.

In Figure 1, 1 is a pre-stage clock generator; 2 is a memory cell array; 3 is an output circuit; 4 is a Schmidt trigger circuit; and 5 is a post-stage clock generator.

The pre-stage clock generator 1 is provided to convert an external input of a TTL (Transistor Transistor Logic) level to an MIS level and to generate clock signals $\phi_1$, $\phi_2$, ... for driving other circuits.

The operation of the circuit shown in Figure 1 can well be understood by reference to Figure 2 of the accompanying drawings which is a time chart illustrating potential variations.

The pre-stage clock generator 1, supplied with an external input, applies the clock signal $\phi_2$ to the gate electrodes of memory cells of the memory cell array 2, (that is, to a word line of the memory cell array) selecting a desired one of the memory cells. Since the word line is made of polycrystalline silicon as mentioned previously, it has a relatively large resistance value and has also a parasitic capacitance thereon; accordingly, when a memory cell connected to a far end of the word line is selected, much time is required for applying a sufficient voltage to that memory cell and reading out therefrom information on a bit line at a required level. As will be seen from Figure 2, there is an appreciable time lag before the potential of the bit line falls sufficiently to cross a reference level (which reference level is dependent on the output circuit 3) after the application of a clock signal $\phi_2$ to the word line. Consequently, if the output circuit 3 is driven by the clock signal $\phi_2$, then erroneous information is output. To avoid this, in the circuit of Figure 1 the clock signal $\phi_2$ is delayed by the Schmidt trigger circuit 4 and then delivered to the post-stage clock generator 5 to derive therefrom a clock signal $\phi_2'$, which lags behind the clock signal $\phi_2$ by a predetermined time interval and the clock signal $\phi_2'$, is applied to the output circuit 3 to activate it, thereby obtaining accurate information.

One specific circuit arrangement for the Schmidt trigger circuit 4 of Figure 1 is shown in Figure 3 of the accompanying drawings which is a circuit diagram.

In Figure 3, $Q_1$ to $Q_4$ are first to fourth transistors; R is a resistor; C is a capacitor; $N_1$ to $N_3$ are first to third nodes; A and B are input terminals; $O_T$ is an output terminal; Vcc is a power source level; Vss is a ground level and $\phi_1$ and $\phi_2$ are clock signals.

The Schmidt trigger circuit of Figure 3 is not subject to any problems in normal operation, but has a defect which is manifest if variations in the power source level arise. This will be described with reference to Figures 4 and 5 of the accompanying drawings which are time charts of potentials.

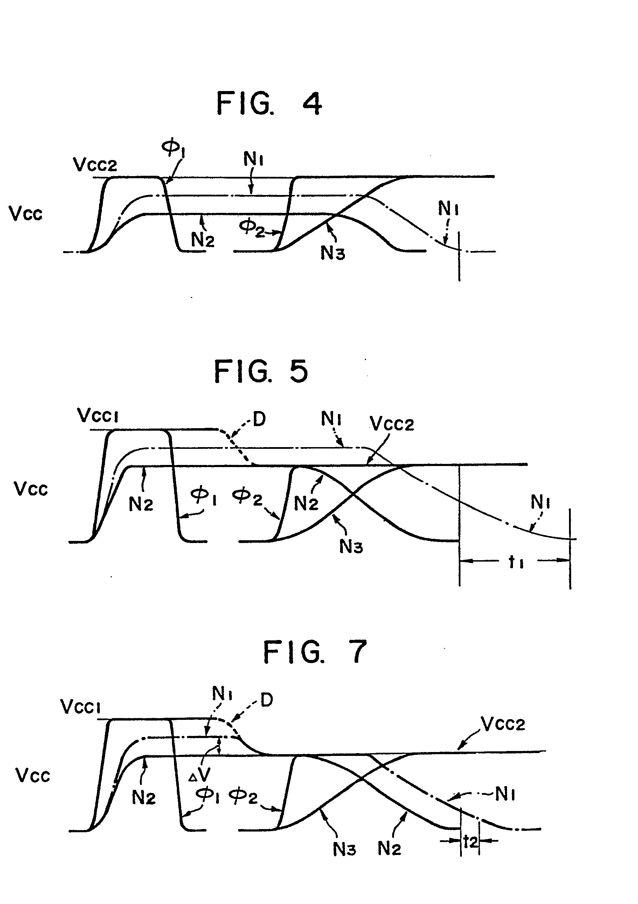

Referring first to Figure 4, a description will be given of normal operation of the circuit of Figure 3 when the power source level Vcc does not vary.

Let it be assumed that the circuit operates at a power source level $Vcc_2$ shown in Figure 4. Upon application of clock signal $\phi_1$ to the input terminal B, the transistor $Q_1$ is turned ON to charge up the node $N_1$ and its level becomes

$$Vcc_2-Vth(Q_1),$$

where $Vth(Q_1)$ is a threshold voltage of the transistor $Q_1$.

When the node $N_1$ is charged up, the transistor $Q_4$ is turned ON to charge up the node $N_2$ and its level becomes

$$Vcc_2-Vth(Q_1)-Vth(Q_4),$$

where $Vth(Q_4)$ is a threshold voltage of the transistor $Q_4$.

In such a state, in which the nodes $N_1$ and $N_2$ have thus been charged up, the clock signal $\phi_1$ at the input terminal B assumes a low level and then clock signal $\phi_2$ is provided to the input terminal A. As a consequence, the node $N_3$ is charged up but its rising-up waveform has a gentle slope as shown in Figure 4 due to the time constant set by the resistor R and the capacitor C. This gentle rise-up due to the time constant provides a desired time lag.

When the node $N_3$ is charged up in excess of the threshold voltage $Vth(Q_3)$ of the transistor $Q_3$, the transistor $Q_3$ is turned ON, with the

result that charges stored at the node $N_2$ are discharged and the level of node $N_2$ starts to drop. At this moment, however, since the transistor $Q_4$ is still in an ON state in which it supplies a current to the node $N_2$, the level of the node $N_2$ drops in dependence upon the gm ratio between the transistors $Q_3$ and $Q_4$. Usually, in a case where gm of the transistor $Q_3$ is 1, gm of the transistor $Q_4$ is selected to be about 10, so that the level of the node $N_2$ falls gently but appreciably.

When the level of the node $N_2$ drops to such an extent that the level difference between the nodes $N_2$ and $N_3$ exceeds the threshold voltage $Vth(Q_2)$ of the transistor $Q_2$, the transistor $Q_2$ is turned ON and the level of the node $N_1$ starts to drop.

Thus, in the Schmidt trigger circuit shown in Figure 3, it is important to make the discharge of the node $N_2$ slow, as a result of the time constant (C×R) (governing charging of node $N_3$), and current feedback from the transistor $Q_4$ to the node $N_2$, thereby achieving a time lag. Because of the current feedback from the transistor $Q_4$ to the node $N_2$, the level of the node $N_1$ does not drop unless the level of the node $N_3$ becomes notably high, that is, unless the level of the node $N_3$ exceeds the sum of the level of the node $N_2$ and the threshold voltage $Vth(Q_2)$. In other words (in the context of Figure 1), the circuit operates after the level of the word line (see Figure 2) has risen sufficiently high, and accordingly, at that moment the level of the bit line rises high above the reference level. It is also an important in the circuit of Figure 3 to obtain a sufficient level margin for the bit line by detecting the level of the word line as described above.

Next, a description will be given, with reference to Figure 5, of an abnormal operation when power source level Vcc fluctuates.

Let it be assumed that the circuit operates at a power source level $Vcc_1$ shown in Figure 5, where $Vcc_1 > Vcc_2$.

Upon application of the clock signal $\phi_1$, the nodes $N_1$ and $N_2$ are charged up as in the case described above.

Next, assume that before the application of the clock signal $\phi_2$, the power source level $Vcc_1$ falls down to a power source level $Vcc_2$ lower than the charge-up level of the node $N_1$, as indicated by the broken line D in Figure 5. At this time, however, the clock signal $\phi_1$ has already started to fall (or has fallen) and the transistor $Q_1$ is in the OFF state, so that charges stored at the node $N_1$ are not discharged to the power source line and the level of the node $N_1$ remains unchanged; in this case, the level stays at the higher level to which the node $N_1$ was charged up, instead of the power source level $Vcc_2$ during the normal operation. As a result of this, a high bias voltage is applied to the transistor $Q_4$, increasing a charge-up current to the node $N_2$.

The gm ratio between the transistors $Q_3$ and $Q_4$ is usually about 1 to 10. When the current to the node $N_2$ is large as mentioned above, however, the apparent gm ratio becomes as large as 1 to 15~20, so that even if the clock signal $\phi_2$ is applied at this time, the drop in level of the node $N_2$ is slowed down, resulting in the discharge of the node $N_1$ being further delayed.

This further delay is indicated by $t_1$ in Figure 5. When such a delay occurs, the delivery of the clock signal $\phi_2'$, from the post-stage clock generator 5, is delayed and the generation of information from the output circuit 3 is also delayed, resulting in the access operation being slowed down as a whole.

It will be understood from the above detailed description of one particular application in which the vulnerability of Schmidt trigger circuit to variations in power source level is explained that in general previously proposed Schmidt trigger circuits are subject to a defect which could give rise to problems in any application for Schmidt trigger circuits.

According to the present invention there is provided a Schmidt trigger circuit having at least first, second and third transistors connected in series between a power source level line and a ground level line, (lines which, when the circuit is in use, receive respectively a power source level and a ground level), and a fourth transistor arranged to be controlled in dependence upon the potential at a first node, at the point of connection between the first and second transistors, for applying a feedback current to a second node, at the point of connection between the second and third transistors, characterised in that a fifth transistor is connected between the power source level line and the first node and is arranged to turn ON when a difference in level between the power source level line and the first node exceeds its threshold voltage.

An embodiment of the present invention can provide for improvement in relation to the above-mentioned defect. An embodiment of the present invention can provide a Schmidt trigger circuit which can reduce delay of access operation resulting from a variation in power source level when applied to the drive circuit of a memory array, for example of a dynamic MIS memory circuit.

Reference is made, by way of example, to the accompanying drawings, in which:—

Figure 1 is a block diagram explanatory of one application of a Schmidt trigger circuit;

Figure 2 is a schematic time chart of variations in potential levels at important points in the circuit of Figure 1;

Figure 3 is a circuit diagram showing principal parts of a Schmidt trigger circuit as previously employed in the circuit of Figure 1;

Figure 4 is a schematic time chart showing variations of potential levels at important points in the circuit of Figure 3, explanatory of normal operation of that circuit;

Figure 5 is a schematic time chart showing

variations in potential levels at important points of the circuit of Figure 3, explanatory of abnormal operation of that circuit;

Figure 6 is a circuit diagram of principal parts of a Schmidt trigger circuit embodying the present invention; and

Figure 7 is a schematic time chart of potential levels at important points of the circuit of Figure 6, explanatory of abnormal operation.

In an embodiment of the present invention when a power source level Vcc drops, the potential at the node $N_1$ is also reduced correspondingly.

Figure 6 illustrates an embodiment of the present invention, in which parts corresponding to those in Figure 3 are identified by the same reference symbols.

The illustrated embodiment differs from the prior art example of Figure 3 in that a fifth transistor $Q_x$ is provided, as shown. The transistor $Q_x$ has its drain connected to the power source line and its gate and source connected to the node $N_1$. It is preferred that the transistor $Q_x$ has a low threshold voltage $Vth(Q_x)$.

Next, a description will be given, with reference to Figure 7, of abnormal operation when the power source level Vcc varies.

Assuming that the nodes $N_1$ and $N_2$ are charged up when the circuit is operating with a power source level $Vcc_1$ and that the power source level then drops down to $Vcc_2$, afterwards, the potential level of the node $N_1$ is higher than the power source level $Vcc_2$, providing therebetween a potential difference $\Delta V$. When the potential difference $\Delta V$ exceeds the threshold voltage $Vth(Q_x)$ of the transistor $Q_x$, the transistor $Q_x$ is turned ON, through which charges stored at the node $N_1$ are discharged onto the power source line to lower the potential level of the node $N_1$ to be substantially equal to

$$Vcc_2+Vth(Q_x).$$

In this way, the potential level of the node $N_1$ drops very rapidly as compared with the potential drop in the conventional circuit as explained above, and consequently the time taken for the potential of the node $N_1$ to reach zero level is markedly reduced, as indicated by $t_2$.

As will be appreciated from the foregoing description, in an embodiment of the present invention, in which Schmidt trigger circuit which is provided with at least first, second and third transistors connected in series between a power source level line and a ground level line, and a fourth transistor which is controlled by the potential at a first node of connection between the first and second transistors to apply a feedback current to a second node of connection between the second and third transistors, there is connected a fifth transistor between the power source level line and the first node for preventing the level of the first node from becoming abnormally high as compared with the level of the power source level line. When the power source level goes down below the level of the first node, the latter is immediately reduced.

Accordingly, when a Schmidt trigger circuit embodying this invention is applied to access circuitry for a memory circuit it is possible to reduce delays in access operation which result from variation in power source level.

Thus, in a Schmidt trigger circuit for delaying a signal, in order to prevent a node connected to the gate of a feedback transistor, for supplying a bias voltage to that gate, being charged up to a high level by an abnormal rise of power source level and then held at that high level regardless of subsequent reduction of the power source level, resulting in a time lag in the reduction of the level at the time of discharging charges stored at the node, whereby the delay of the signal becomes undesirably large, a transistor is connected between the node and the power source line and when the level difference therebetween exceeds the threshold voltage of the transistor, the transistor is turned ON to discharge therethrough charges of the node to the power source line.

In the illustrated embodiment of the present invention three transistors are connected in series between the power source line and the ground (or low level line); of course, more than three transistors may be connected in series.

## Claims

1. A Schmidt trigger circuit having at least first ($Q_1$), second ($Q_2$) and third ($Q_3$) transistors connected in series between a power source level ($V_{cc}$) line and a ground level ($V_{ss}$) line (lines which, when the circuit is in use, receive respectively a power source level and a ground level) and a fourth transistor ($Q_4$) arranged to be controlled in dependence upon the potential at a first node ($N_1$), at the point of connection between the first ($Q_1$) and second ($Q_2$) transistors, for applying a feedback current to a second node ($N_2$), at the point of connection between the second ($Q_2$) and third ($Q_3$) transistors, characterised in that a fifth transistor ($Q_x$) is connected between the power source level ($V_{cc}$) line and the first node ($N_1$) and is arranged to turn ON when a difference in level between the power source level ($V_{cc}$) line and the first node ($N_1$) exceeds its threshold voltage.

2. A Schmidt trigger circuit as claimed in claim 1, wherein the first to fifth transistors are FETs, and wherein the drain of the fifth ($Q_x$) transistor is connected to the power source level ($V_{cc}$) line, and the source and gate of the fifth transistor ($Q_x$) are connected to the first node ($N_1$).

3. A Schmidt trigger circuit as claimed in claim 1 or 2, wherein the fifth transistor ($Q_x$) has a low threshold voltage.

4. A Schmidt trigger circuit as claimed in claim 1, 2 or 3, arranged in access circuitry for a memory circuit.

5. A memory circuit including a Schmidt trigger circuit as claimed in any preceding claim.

6. A dynamic MIS memory circuit including a Schmidt trigger circuit as claimed in any one of claims 1 to 4.

**Revendications**

1. Circuit de déclenchement de Schmidt comportant au moins un premier ($Q_1$), un deuxième ($Q_2$) et un troisième ($Q_3$) transistors connectés en série entre une ligne de niveau de tension (Vcc) de source d'alimentation et une ligne de niveau de masse (Vss) (ces lignes recevant respectivement un niveau de tension de source d'alimentation et un niveau de masse quand le circuit est utilisé) et un quatrième transistor ($Q_4$) disposé pour être commandé en fonction de la tension à un premier noeud ($N_1$), au point de connextion entre le premier ($Q_1$) et le deuxième ($Q_2$) transistors, pour appliquer un courant de réaction à un deuxième noeud ($N_2$), au point de connexion entre le deuxième ($Q_2$) et le troisième ($Q_3$) transistors, caractérisé en ce qu'un cinquième transistor ($Q_x$) est connecté entre la ligne de niveau de tension (Vcc) de source d'alimentation et le premier noeud ($N_1$) et disposé pour être conducteur quand une différence de niveau entre la ligne de niveau de tension (Vcc) de source d'alimentation et le premier noeud ($N_1$) dépasse sa tension de seuil.

2. Circuit de déclenchement de Schmidt selon la revendication 1, caractérisé en ce que les premier au cinquième transistors sont des transistors à effet de champ FET, et en ce que le drain de cinquième transistor ($Q_x$) est connecté à la ligne de niveau de tension (Vcc) de source d'alimentation et la source et la grille du cinquième transistor ($Q_x$) sont connectées au premier noeud ($N_1$).

3. Circuit de déclenchement de Schmidt selon l'une quelconque des revendications 1 et 2, caractérisé en ce que le cinquième transistor ($Q_x$) a une tension de seuil faible.

4. Circuit de déclenchement de Schmidt selon l'une quelconque des revendications 1 à 3, caractérisé en ce qu'il est disposé dans un circuit d'accès pour un circuit de mémoire.

5. Circuit de mémoire incluant un circuit de déclenchement de Schmidt tel que revendiqué dans l'une quelconque des revendications précédentes.

6. Circuit de mémoire dynamique MIS incluant un circuit de déclenchement de Schmidt tel que revendiqué dans l'une quelconque des revendications 1 à 4.

**Patentansprüche**

1. Schmitt-Trigger-Schaltung mit wenigstens einem ersten ($Q_1$), einem zweiten ($Q_2$) und einem dritten ($Q_3$) Transistor, die in Reihe zwischen einer Energiepotentialleitung ($V_{cc}$) und einer Erdpotentialleitung ($V_{ss}$) liegen (Leitungen, die im Betrieb der Schaltung ein Energiequellenpotential bzw. ein Erdpotential empfangen), und mit einem vierten Transistor ($Q_4$), der in Abhängigkeit von dem Potential bei einem ersten Knotenpzunkt ($N_1$), an einem Verbindungspunkt zwischen dem ersten ($Q_1$) und dem zweiten ($Q_2$) Transistor, gesteuert wird, um einen Rückkopplungsstrom einem zweiten Knotenpunkt ($N_2$), an einem Verbindungspunkt zwischen dem zweiten ($Q_2$) und dem dritten ($Q_3$) Transistor zu liefern, dadurch gekennzeichnet, daß ein fünfter Transistor ($Q_x$) zwischen der Energiepotentialleitung ($V_{cc}$) und dem ersten Knotenpunkt ($N_1$) so geschaltet ist, daß er einschaltet, wenn die Potentialdifferenz zwischen der Energiepotentialleitung ($V_{cc}$) und dem ersten Knotenpunkt ($N_1$) eine bestimmte Schwellenwertspannung überschreitet.

2. Schmitt-Trigger-Schaltung nach Anspruch 1, bei der der erste und der fünfte Transistor FETs sind und die Drain des fünften Transistors ($Q_x$) mit der Energiepotentialleitung ($V_{cc}$) und Source und Gate des fünften Transistor ($Q_x$) mit dem ersten Knotenpunkt ($N_1$) verbunden sind.

3. Schmitt-Trigger-Schaltung nach Anspruch 1 oder 2, bei der der fünfte Transistor ($Q_x$) eine niedrige Schwellenwertspannung hat.

4. Schmitt-Trigger-Schaltung nach Anspruch 1, 2 oder 3, angeordnet in einer Zugriffsschaltung für eine Speicherschaltung.

5. Speicherschaltung mit einer Schmitt-Trigger-Schaltung nach einem der vorhergehenden Ansprüche.

6. Dynamische MIS-Speichersschaltung mit einer Schmitt-Trigger-Schaltung nach einem der Ansprüche 1 bis 4.

FIG. 1

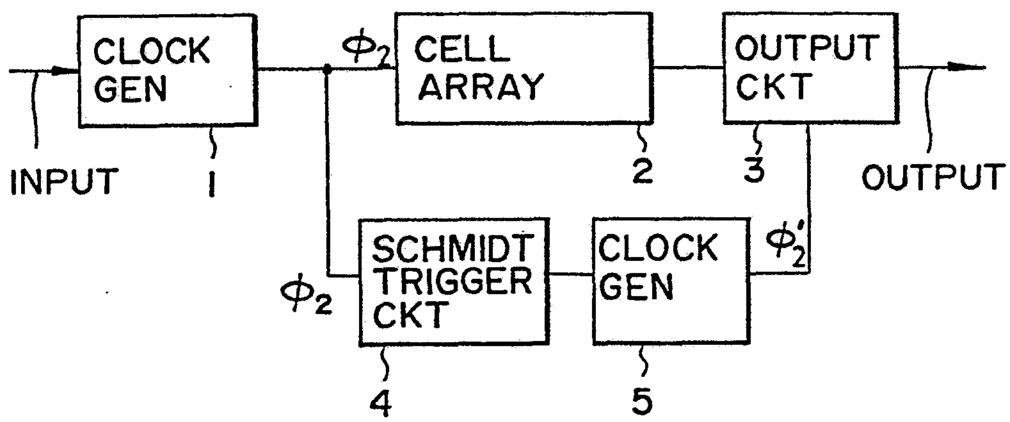

CLOCK GEN
$\phi_2$
CELL ARRAY
OUTPUT CKT
INPUT
1
2
3
OUTPUT
SCHMIDT TRIGGER CKT
CLOCK GEN
$\phi_2'$
$\phi_2$
4
5


FIG. 2

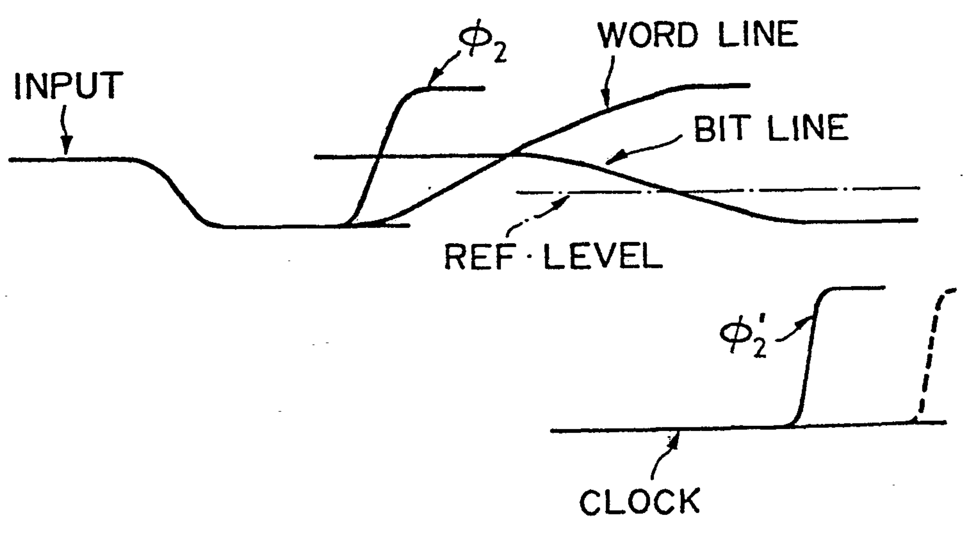

$\phi_2$
WORD LINE
INPUT
BIT LINE
REF · LEVEL
$\phi_2'$
CLOCK

FIG. 3

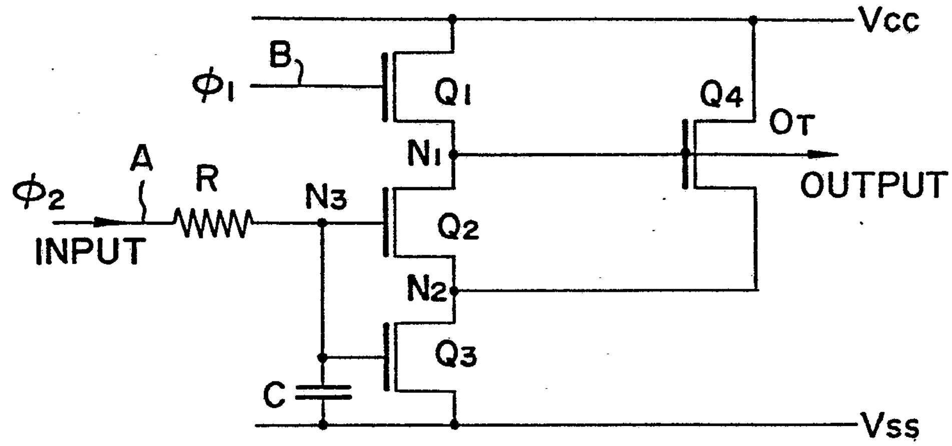
Vcc
B
Φ1
Q1
Q4
OT
N1
OUTPUT
Φ2
A
R
N3
INPUT
Q2
N2
Q3
C
Vss

FIG. 6

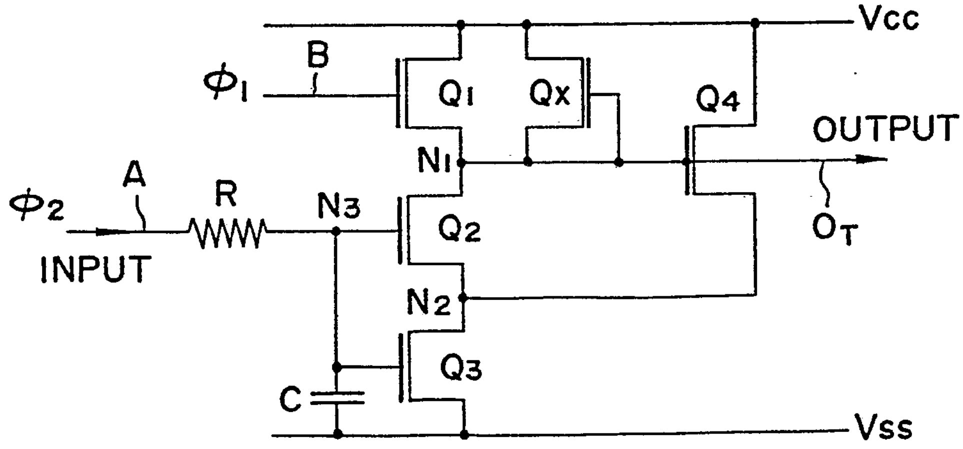
Vcc
B
Φ1
Q1
Qx
Q4
OUTPUT
N1
Φ2
A
R
N3
INPUT
Q2
OT
N2
Q3
C
Vss

FIG. 4

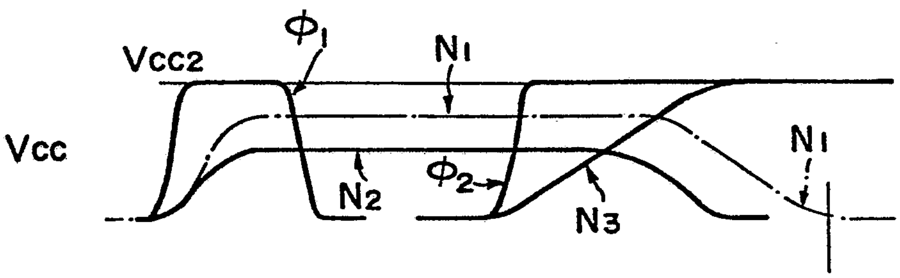


FIG. 5

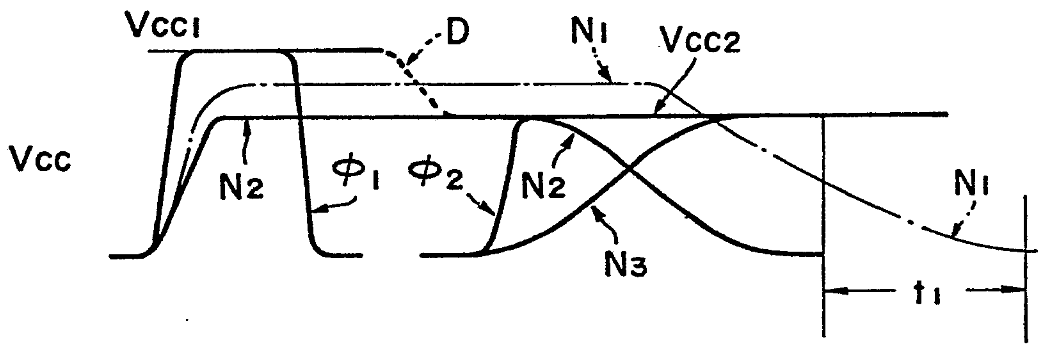


FIG. 7